## Europäisches Patentamt
## European Patent Office
## Office européen des brevets

(11) Publication number: **0 225 224**
A2

# EUROPEAN PATENT APPLICATION

(21) Application number: **86402365.0**

(22) Date of filing: **22.10.86**

(51) Int. Cl.⁴: **H 01 L 21/285**
**H 01 L 21/90, H 01 L 21/316**

(30) Priority: **29.10.85 US 792466**

(43) Date of publication of application:
**10.06.87 Bulletin 87/24**

(84) Designated Contracting States:
**AT DE FR GB IT NL**

(71) Applicant: **THOMSON COMPONENTS-MOSTEK
CORPORATION
1310 Electronics Drive
Carrollton Texas 75006 (US)**

(72) Inventor: **Craig, Clay Hafer
THOMSON-CSF SCPI 19, avenue de Messine
F-75008 Paris (FR)**

(74) Representative: **Ruellan-Lemonnier, Brigitte et al
THOMSON-CSF SCPI 19, avenue de Messine
F-75008 Paris (FR)**

(54) After oxide metal alloy process.

(57) A process for manufacturing a semiconductor device eliminating a post-metalization heat treatment that results in fewer hillocks and improved ohmic contacts. Semiconductor devices having metalization are processed by maintaining the device at a first temperature below about 275°C subsequent to the deposition of the metalization layer and prior to the deposition of the topcoat silicon dioxide material. Then the layer of silicon dioxide is deposited at a second temperature greater than about 375 C. Preferably, double-level metalization devices are processed by maintaining the device at a first temperature below about 275 C subsequent to the deposition of the first layer of metal and prior to the deposition of the interlevel dielectric silicon dioxide. The interlevel dielectric layer of silicon dioxide is deposited at a second temperature greater than about 275 C and then the second layer of metalization is deposited. The topcoat layer of silicon dioxide is deposited at a third temperature greater than about 375°C.

EP 0 225 224 A2

**Description**

After Oxide Metal Alloy Process

Technical Field

The invention relates to heat treatments associated with metal deposition in semiconductor processes.

Background Art

Typically a heat treatment alloy process step is employed after metalization in semiconductor manufacture to improve ohmic contact between a metal layer and the substrate layer beneath. See, for instance, U.S. Patent No. 3,887,993. The process is also referred to as annealing or sintering as discussed in U.S. Patent Nos. 3,889,359, 3,923,559, and 4,328,261.

A typical alloy process step involves heating the wafer at about 425°C in the presence of hydrogen. The heat improves the low resistance (ohmic contact) between metal and N+ and metal and P+ diffusion regions and metal and polycrystaline silicon. In addition, the hydrogen diffuses through the wafer to the gate-oxide active interface area and serves to tie up surface states (dangling bonds) and stabilize the threshold voltage ($V_t$) thereat.

It is believed that post metal deposition heat treatments such as the alloy process can affect the metal structure. This structural change lends itself to yield problems (potentially contributing to metal-to-metal shorts in double level metal processes), bonding problems (affecting film hardness), and reliability problems (causing metal cracking and glass pinholes).

Accordingly, there is a constant search in this art for methods that incorporate alternative process technology.

Disclosure of the Invention

This invention eliminates the conventional post-metalization alloy process step, resulting in fewer hillocks per square centimeter (hillocks/cm$^2$) of metal area and decreased ohmic contact resistance.

This invention is directed at a method of manufacturing a semiconductor device by depositing a layer of metalization and a layer of silicon dioxide. In this process, the device is maintained at a first temperature below about 275°C subsequent to the deposition of the layer of metal and prior to the deposition of the silicon dioxide. The layer of silicon dioxide is deposited at a second temperature greater than about 375°C.

Another aspect of this invention is a method for processing a double-level metalization semiconductor device that results in fewer hillocks/cm$^2$ of metal area and lower ohmic contact. A first layer of metal, an interlevel dielectric layer of silicon dioxide, a second layer of metal and a topcoat layer of silicon dioxide are deposited. In this process, the device is maintained at a first temperature below about 275°C subsequent to the deposition of the first layer of metal and prior to deposition of the interlevel dielectric layer of silicon dioxide. The interlevel dielectric layer of silicon dioxide is deposited at a second temperature less than about 425°C and then the second layer of metalization is deposited. The topcoat layer of silicon dioxide is deposited at a third temperature greater than about 375°C.

These processes eliminate the post metalization heat treatment process reducing the number of hillocks and surprisingly improving the ohmic contact resistance. Thus, this invention provides critical process technology that makes a significant advance in the field of semiconductor devices.

The foregoing and other objects, features and advantages will be apparent from the specification and claims from the accompanying drawing which will illustrate an embodiment of the invention.

Brief Description of the Drawings

Figure 1 is an exemplary drawing of a single level metal CMOS device.

Figure 2 is an exemplary drawing of a double level metal CMOS device.

Figure 3A and 3B illustrate the reduced number of hillocks in devices that were processed according to this invention in comparison to devices which were processed with a post metalization heat treatment.

Figure 4 is a graph illustrating the low resistance contact between metal 1 and P+ diffusion regions of double level metal devices that were processed according to this invention in comparison to devices which were processed with a post metalization heat treatment.

Figure 5 is a graph illustrating the low resistance contact between metal 1 and N+ diffusion regions of double level metal devices that were processed according to this invention in comparison to devices which were processed with a post metalization heat treatment.

Figure 6 is a graph illustrating the low resistance contact between metal 1 and polycrystaline silicon regions of double level metal devices that were processed according to this invention in comparison to devices which were processed with a post metalization heat treatment.

Figure 7 is a graph illustrating the $V_tN$ stabilization of double level metal devices that were processed according to this invention in comparison to devices which were processed with a post metalization heat treatment.

Figure 8 is a graph illustrating the $V_tP$ stabilization of double level metal devices that were processed according to this invention in comparison to devices which were processed with a post metalization heat treatment.

Best Mode for Carrying Out the Invention

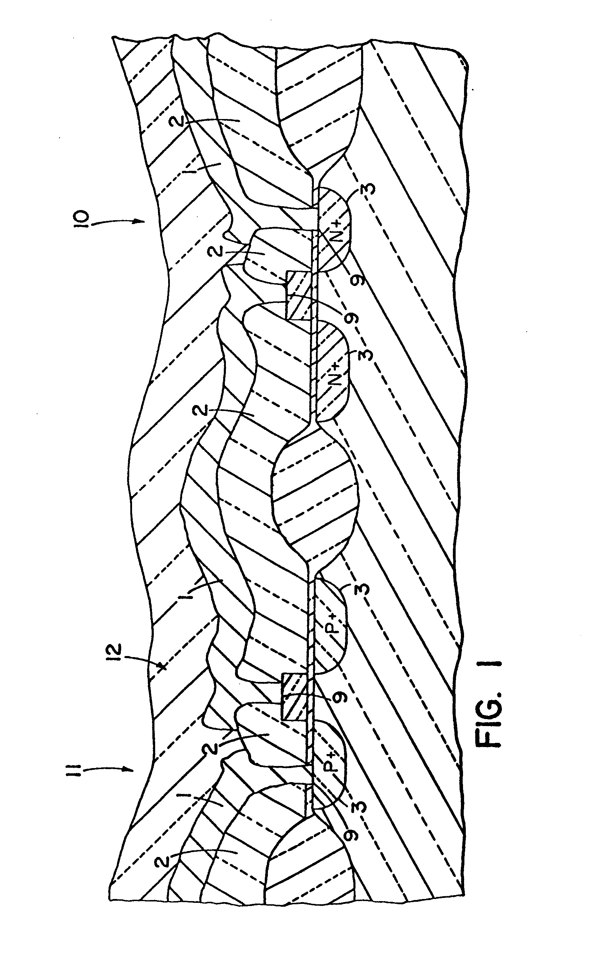

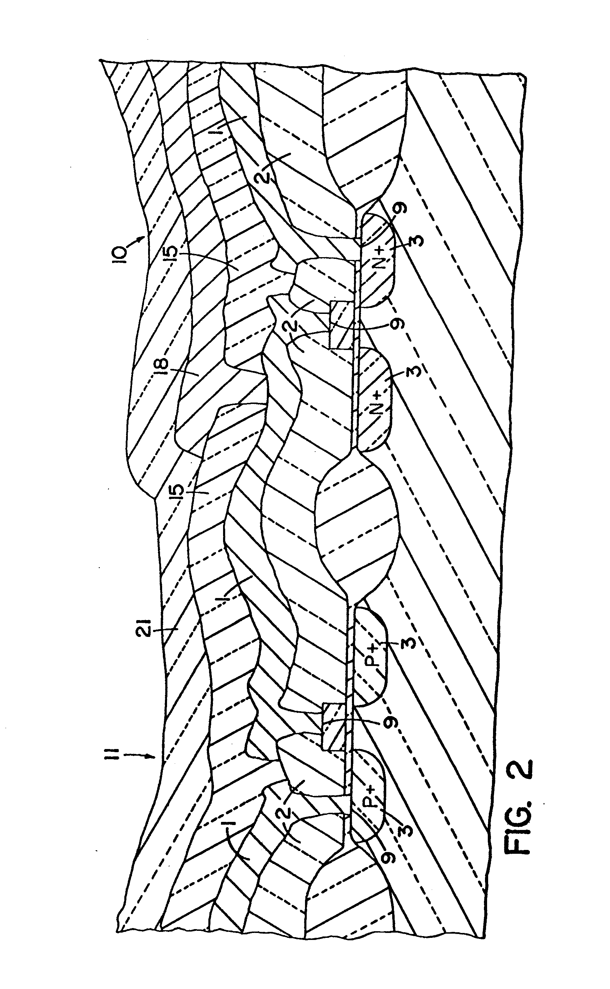

A clearer understanding of this invention may be had by reference to Figs. 1 and 2, single level and double level metal CMOS devices respectively. A sequence of conventional steps are employed for fabricating n 10 and p 11 channel junction devices in an integrated circuit such as a CMOS device. According to this invention a layer of metalization 1 is deposited by, for example, sputtering or evaporation upon a layer of insulating silicon dioxide 2 or, at the contact holes, silicon 3. Metal deposition can be accomplished using a Varian 3180 or 3190 sputterer. The silicon dioxide is preferably doped with about 6% to about 10% phosphorous. It is especially preferred that the silicon dioxide layer is doped with about 8% phosphorous so that at elevated processing temperatures, the silicon dioxide will flow and smooth over the steps resulting in good metal step coverage.

This metal layer is typically about 5 kiloangstroms (KA) to about 14 KA preferably about 9 KA to about 14 KA. It is especially preferred that the metal layer is about 10.5 KA in thickness. It is typically deposited by, for example, sputtering or evaporation. The metal layer is comprised of aluminum or alloys of aluminum. The choice of these materials arises from their advantageous metallurgical and electrical properties such as:

1. Low resistivity of interconnections.
2. Adherence of the metal interconnections to oxide insulating layers.
3. Low ohmic-nonrectifying contacts to silicon
4. Stability of contacts (both electrically and physically) to other conducting layers.
5. Capability of being defined in fine pattern geometry with the photolithographic process.
6. Etchability by means of plasma methods.
7. Resistance to electromigration.
8. VLSIC process economy.

By alloys of aluminum is meant materials having aluminum present in greater than a 90 percent by weight (%) amount. Thus, preferably aluminum may be alloyed with other materials such as about 0% to about 2.5% copper and about 0.5% to about 3% silicon. It is especially preferred to use about 0.5% copper and about 1% silicon. Although higher percentages of copper, for example, about 3% copper can result in fewer hillocks/cm[2] of metal interconnect line area, it is typically difficult to define these geometrically by modern-day plasma etch techniques.

According to the present invention, it is important to maintain the temperature of the device subsequent to metalization below about 275°C and preferably below about 215°C. These temperatures are to be maintained during subsequent conventional process steps, for example, dehydration bake, resist bake, and metal definition etch until the deposition of a layer of silicon dioxide.

Typically, subsequent to metalization the device undergoes thermal cycling, for example, the aluminum is alloyed at about 425°C to form low resistance contact. Specifically at the silicon contacts there is a thin covering layer of naturally occurring silicon dioxide 9 which is in contact with the aluminum. At elevated temperatures the silicon dioxide layer reacts with the aluminum to form alumina ($Al_2O_3$) and silicon. Empirically, this can be illustrated as $Al + SiO_2 \rightarrow Al_2O_3 + Si$. This sintering

(i.e. alloying, annealing) step aids in forming aluminum-silicon electrical contacts possessing acceptable ohmicity and in stabilizing $V_t$.

However, it is believed that the heat treatments can generate vertical aluminum protrusions (or hillocks). It is believed that hillocks are a product of stress enhanced diffusion from the aluminum/$SiO_2$ interface due to the mismatch in the thermal coefficients of expansion between the dissimilar materials. Note commonly-assigned copending application Serial No. B-4042. The size and number of hillocks generated is somewhat proportional to the temperature and the time the wafer is exposed to that temperature (temperature being the dominant factor). As the size of the hillocks increases, the probability of an electrical short from metal layer to metal layer in multiple level devices increases. Only one short is required to render a potentially good device functionally dead. Using the process of this disclosure enables the elimination of the post metalization heat treatment and resultant hillocks but surprisingly, the process still results in the low resistance contacts described earlier.

According to this invention during deposition of a layer of silicon dioxide, as the topcoat 12 in single level metalization or as the interlevel dielectric 15 in multiple level metalization, the temperature can be raised with less serious consequences. It is believed that the silicon dioxide layer acts as a hillock inhibiting surface such that during or preferably after deposition of silicon dioxide the temperature can be raised and cause fewer of the above-described problems such as hillocks. In single level metalization hillocks cannot short circuit a second metalization layer, however, they do cause pinholes which can cause reliability problems.

The silicon dioxide topcoat layer which can be doped with about 3% to about 5%, preferably about 4% phosphorous is typically about 7 KA to about 16 KA in thickness and preferably about 10 KA in thickness. Thus, for single level metalization, it is preferred that the silicon dioxide topcoat is deposited at a temperature greater than about 375°C as this temperature alloys the aluminum providing low resistance contacts yet the silicon dioxide deposition results in less hillocks/cm[2]. Preferably, the alloying occurs at about 385°C to about 450°C as above 450°C metal weaknesses can occur; for example, aluminum melts at about 500°C.

Preferably the silicon dioxide topcoat layer as described above is deposited by atmospheric chemical vapor deposition (CVD) with silane and an excess molar equivalent of oxygen over a period of about 5 minutes to about 35 minutes as this results in a hydrogen atmosphere which aids in stabilizing $V_t$. An AMS 2000 equipment available from Applied Materials System can be used. An excess of oxygen is used to completely react the silane as silane is extremely flammable.

In application to multiple level metalizations, the silicon dioxide layer referred to would be a topcoat or dielectric layer(s) which has had an interlevel dielectric layer of silicon dioxide deposited previously on the wafer at a temperature below about 310°C preferably from about 275°C to about 310°C.

The fact that there is a layer of silicon dioxide deposited prior to elevating the temperature above 310°C results in greater advantages such as fewer hillocks/cm² than in single level metalization where the layer of silicon dioxide is deposited simultaneously to elevation of the temperature above 375°C. The thickness of interlevel dielectric layers is typically about 6 KA to about 10 KA, preferably about 8 KA. The deposition of an interlevel dielectric layer of $SiO_2$ is described below.

Another aspect of this invention relates specifically to devices having double-level metalization. In these devices, the above-described process is used however before the silicon dioxide topcoat is deposited at a temperature above 375°C an interlevel dielectric layer of silicon dioxide is deposited followed by a second metalization layer 18.

Specifically, a first layer of metal 1 about 5.0 KA to about 8.0 KA, preferably about 6.0 KA in thickness is deposited by conventional means such as sputtering. A Varian 3180 or 3190 sputterer may be used for metal deposition. Then an interlevel dielectric layer 15 of silicon dioxide about 6 KA to about 10 KA preferably about 8 KA in thickness (depending on the thicknesses of various steps) is deposited at a temperature less than about 425°C. Preferably the silicon dioxide is deposited at a temperature between about 275°C and about 310°C as it is believed that this intermediate heat treatment aids in alloying the first metalization layer and yet causes few hillocks. It is especially preferred that a planarization process is used, for example, the deposition and etchback of several layers of $SiO_2$ as this results in a smoother surface. Preferably the interlevel dielectric silicon dioxide is deposited by Plasma Enhanced Chemical Vapor Deposition (PECVD) using a 3300 AMP available from Applied Materials Plasma by exposing the device to silane and an excess molar equivalent of oxygen over a period of about 10 minutes to about 50 minutes at about 200 millitorr (mT) pressure to about 400 mT pressure. Following interlevel dielectric oxide deposition, a second metalization layer 18 is deposited by conventional means. Again, a Varian 3180 or 3190 may be used. The second metalization layer has a thickness of about 9 KA to about 14 KA, preferably about 10.5 KA.

A topcoat layer of silicon dioxide 21 is then deposited. The topcoat is typically of two types. For plastic packages it typically comprises a silicon dioxide layer of about 2 KA to about 6 KA, preferably about 4 KA thickness. A silicon nitride layer of about 7 KA to about 13 KA, preferably about 10 KA is preferably applied over the silicon dioxide affording protection from moisture as the plastic encapsulant can allow the penetration of moisture. For ceramic packages, the topcoat typically comprises a layer of silicon dioxide about 7 KA to about 16 KA, preferably about 10 KA in thickness. Preferably the silicon dioxide layer is doped with about 3% to about 5% phosphorous as this can prevent the silicon dioxide topcoat (film) from cracking.

Typically, the silicon dioxide topcoat (either undoped or phosphorous doped) is CVD deposited at atmospheric pressure and a temperature greater than about 375°C. Preferably the temperature is about 375°C to about 450°C and it is especially preferred that it is about 420°C as this aids in topcoat deposition and annealing the aluminum, thus improving the low resistance contacts. However, it is believed that since the first metalization layer has a protective interlevel dielectric (silicon dioxide) covering it, the subsequent higher temperature oxide deposition does not cause significant numbers of hillocks. Preferably, as before, the silicon dioxide topcoat layer is deposited by exposing the device to silane and an excess molar equivalent of oxygen over a period of about 5 minutes to about 35 minutes at atmospheric. For the plastic packages, the silicon nitride is typically deposited at about 275°C to about 310°C, preferably about 290°C by a PECVD process using a 3300 AMP Reactor available from Applied Materials Plasma.

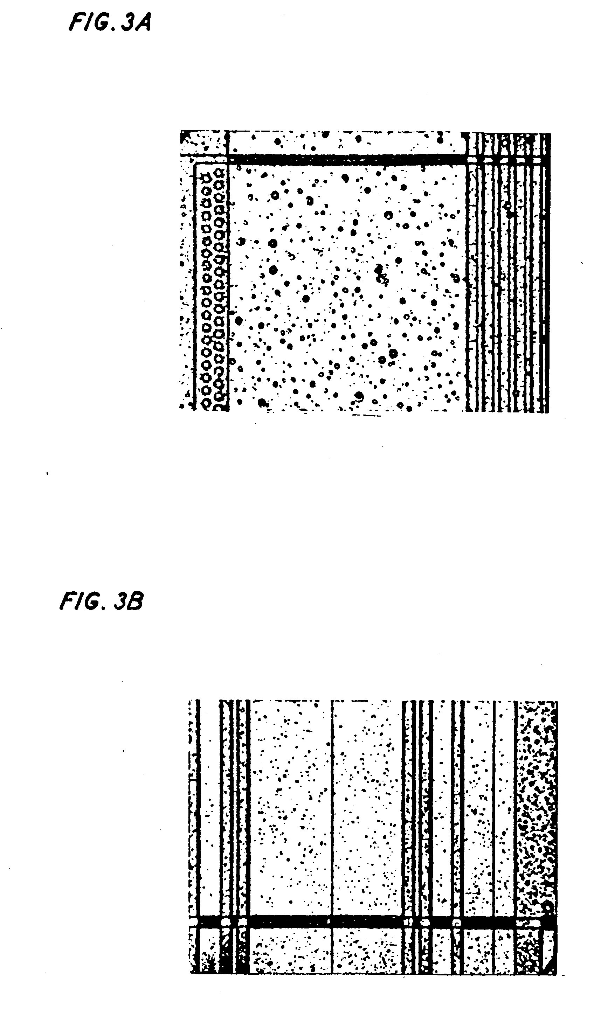

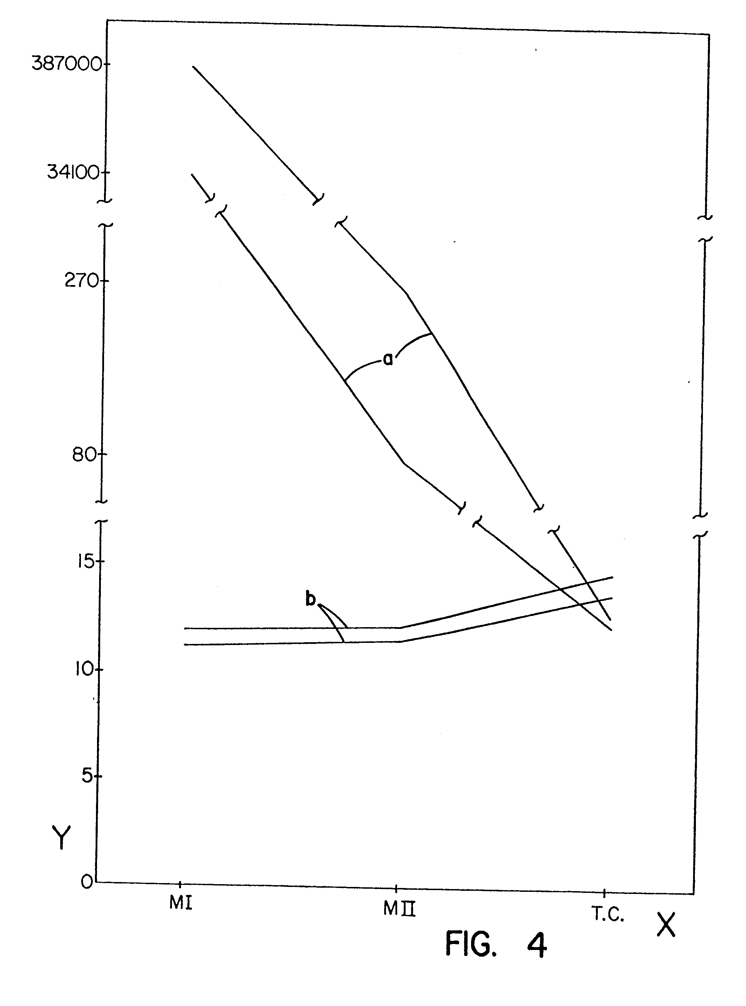

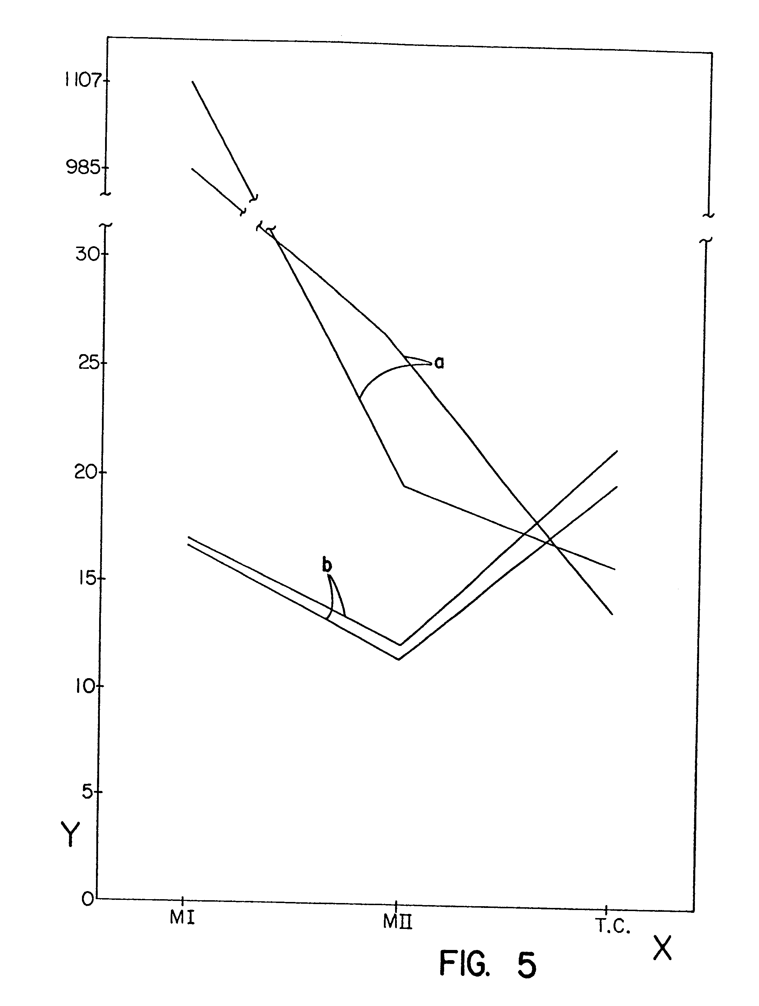

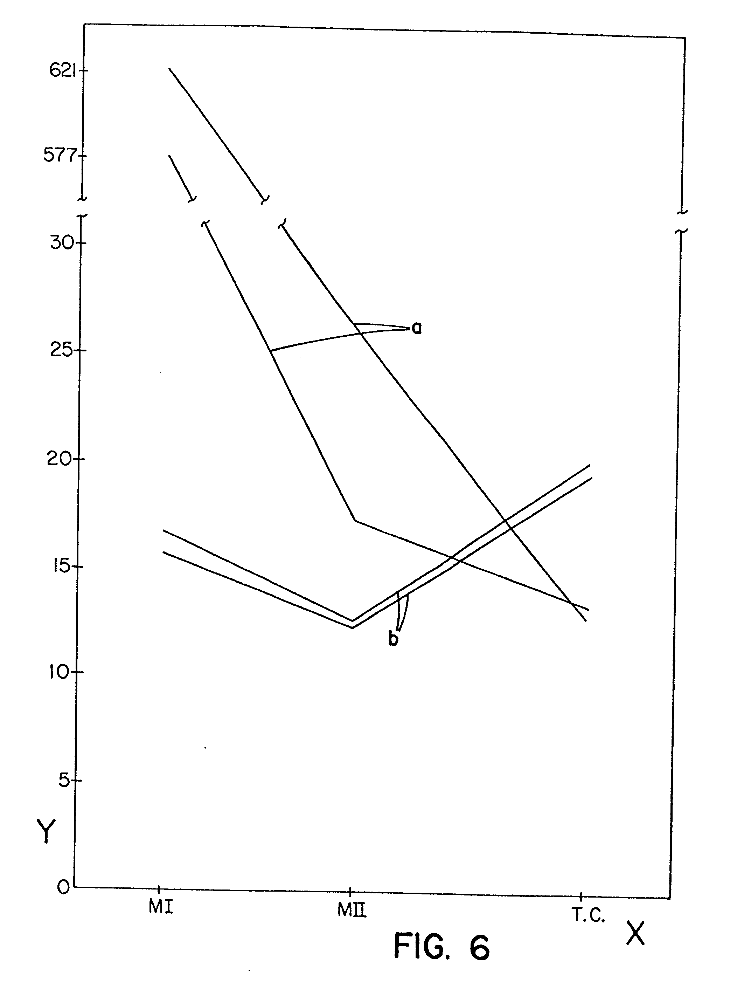

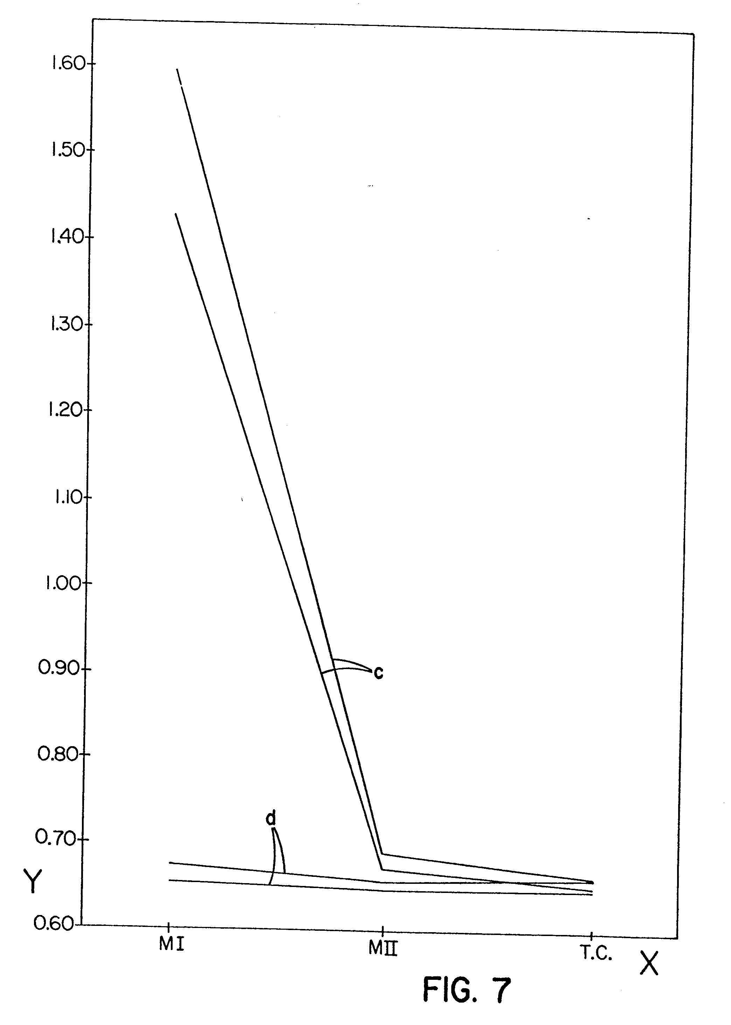

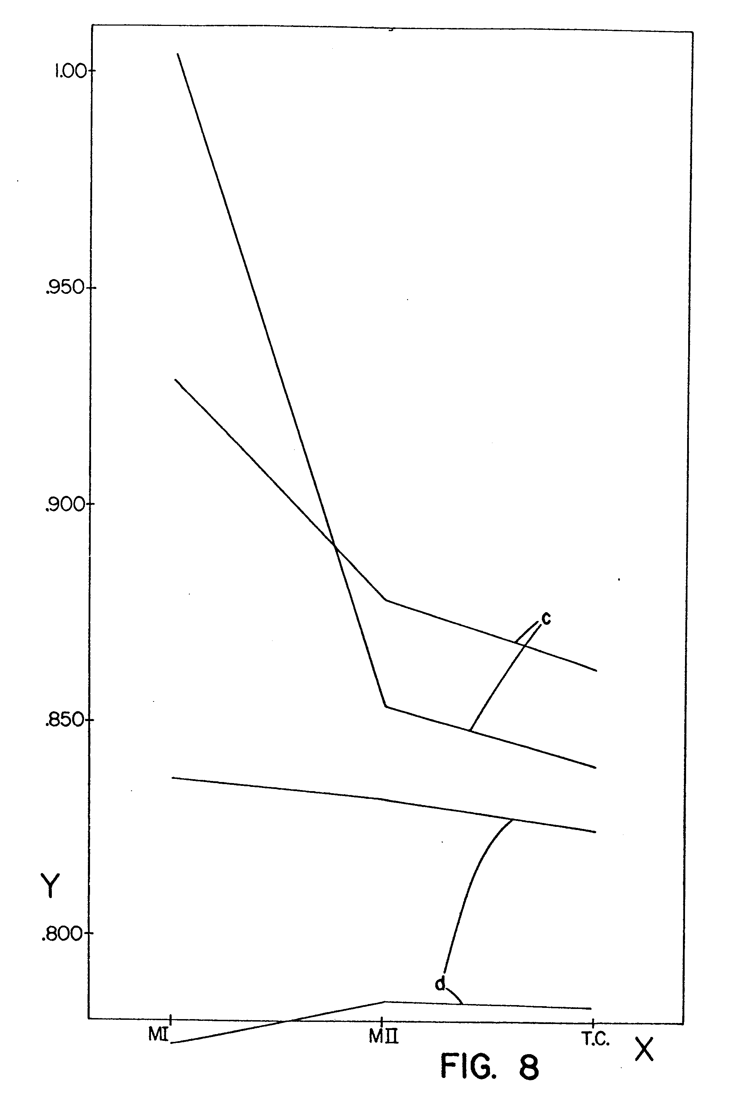

These processes may be used for making semiconductor devices with single, double or multiple levels of metalization. By eliminating a post metalization heat treatment previously thought critical to the formation of low resistance contacts and the stabilization of $V_t$, a major cause of hillocks has been eliminated. Particularly when employed in double-level metalization device processes, these discoveries are important as they significantly reduce the number of hillocks thus reducing the number of potential shorts from metal to metal. This is evident with reference to Figures 3A and 3B which show pictures of two sets of devices; one set having significant numbers of hillocks 3A and the other set 3B having a vastly reduced number of smaller hillocks. The former set was processed using a conventional post metalization heat treatment while the latter was processed according to this invention. In addition, as evident from Figures 4-8, without the conventional post metalization heat treatment, the contacts are surprisingly lower in resistance after topcoat deposition and $V_t$ is comparable. Figures 4-6 are graphs of the contact resistance of $M_1$ to P+, $M_1$ to N+ and $M_1$ to polycrystaline respectively. In each figure the respective contact in ohms (y) is graphed as a function of three different points in the device's manufacturing process (x), namely $M_1$, $M_2$ and topcoat. In these figures the devices processed by this invention (a) are typically lower at the final topcoat stage than devices (b) processed with a conventional post metalization heat treatment. Figures 7 and 8 are respectively graphs of $V_t$ stabilization for an N channel transistor on a CMOS device and a P channel transistor on a CMOS device. In each figure volts (y) for the transistor are given as a function of three different process points in the device's manufacturing process (x) namely $M_1$, $M_2$ and topcoat. In these figures the devices processed by this invention (c) have comparable $V_t$ stabilization to devices (d) processed with a conventional post metalization heat treatment. Thus, this invention provides process knowledge that makes a significant advance in the field of semiconductor devices.

It should be understood that the invention is not limited to the particular embodiment shown and described herein, but that various changes and modifications may be made without departing from the spirit or scope of this concept as defined by the following claims.

## Claims

1. A method of manufacturing a semiconductor device by depositing a layer of metalization and depositing a layer of silicon dioxide wherein the improvement comprises:

a) maintaining the device at a first temperature below about 275°C subsequent to the deposition of the layer of metal and prior to the deposition of the silicon dioxide; and

b) depositing the layer of silicon dioxide at a second temperature greater than about 375°C, resulting in fewer hillocks per square centimeter of metal area and a lower ohmic contact.

2. The method as recited in claim 1 wherein the first temperature is maintained below about 215°C.

3. The method as recited in claim 1 wherein a dielectric layer of silicon dioxide is deposited at a temperature below about 310°C prior to deposition of the layer of silicon dioxide at the second temperature greater than about 375°C.

4. The method of processing a double-level metalization semiconductor device by depositing a first layer of metal, depositing an interlevel dielectric layer of silicon dioxide, depositing a second layer of metalization and depositing a topcoat layer of silicon dioxide wherein the improvement comprises:

a) maintaining the device at a first temperature below about 275°C subsequent to the deposition of the first layer of metal and prior to the deposition of the interlevel dielectric layer of silicon dioxides;

b) depositing the interlevel dielectric layer of silicon dioxide at a second temperature less than about 425°C;

c) depositing the second layer of metalization; and

d) depositing the topcoat layer of silicon dioxide at a third temperature greater than about 375°C,

resulting in fewer hillocks per square centimeter of metal area and a lower ohmic contact.

5. The method as recited in claim 4 wherein the first temperature is maintained at a temperature lower than about 215°C.

6. The method as recited in claim 5 wherein the interlevel dielectric layer of silicon dioxide is deposited at a second temperature from about 275°C to about 310°C.

FIG. I

FIG. 2

*FIG. 3A*

*FIG. 3B*

FIG. 4

FIG. 5

FIG. 6

FIG. 7

0225224

FIG. 8